(19) Europäisches Patentamt
European Patent Office
Office européen des brevets

(11) **EP 2 996 040 A1**

(12) **DEMANDE DE BREVET EUROPEEN**

(43) Date de publication:
**16.03.2016 Bulletin 2016/11**

(51) Int Cl.:
*G06F 9/50* (2006.01)     *G06F 17/50* (2006.01)

(21) Numéro de dépôt: **15181636.0**

(22) Date de dépôt: **19.08.2015**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**MA**

(30) Priorité: **02.09.2014 FR 1401942**

(71) Demandeurs:
• **THALES**
**92400 Courbevoie (FR)**
• **UNIVERSITE DE NANTES**
**44035 Nantes Cedex 1 (FR)**

(72) Inventeurs:
• **BRILLU, Romain**
**78851 Elancourt Cedex (FR)**
• **MILLET, Philippe**
**91767 Palaiseau (FR)**
• **PILLEMENT, Sébastien**
**44300 Nantes (FR)**
• **LEMONNIER, Fabrice**
**91767 Palaiseau (FR)**

(74) Mandataire: **Blot, Philippe Robert Emile**
**Cabinet Lavoix**
**2, place d'Estienne d'Orves**
**75441 Paris Cedex 09 (FR)**

(54) **PROCÉDÉ DE DÉTERMINATION PAR OPTIMISATION D'UNE ARCHITECTURE MULTI-COEURS**

(57)     L'invention concerne un procédé de détermination par optimisation d'une architecture muiti-coeurs et d'une façon d'implémenter une application sur l'architecture pour une application donnée, le procédé comprend :
- la fourniture d'une application parallélisée et d'architectures candidates comprenant différents blocs matériels,
- la définition d'un premier espace d'exploration ayant pour éléments les différentes façons d'implémenter l'application sur chacune des architectures candidates;
- la sélection dans le premier espace d'exploration des éléments vérifiant un critère pour obtenir un deuxième espace d'exploration,
- la détermination dans le deuxième espace d'exploration des éléments vérifiant un critère pour obtenir un troisième espace d'exploration,
- le calcul du nombre de données échangées entre les blocs matériels pour chacun des éléments du troisième espace d'exploration pour obtenir un quatrième espace d'exploration, et
- l'optimisation des éléments du quatrième espace d'exploration selon un critère.

FIG.2

**Description**

La présente invention concerne un procédé de détermination par optimisation d'une architecture multi-coeurs et d'une façon d'implémenter une application sur l'architecture pour une application donnée. La présente invention se rapporte également au produit programme d'ordinateur associé.

Une architecture multi-coeurs est une plateforme de calcul comprenant plusieurs unités de traitement ou coeurs de traitement. Chaque unité de traitement est notamment apte à exécuter des programmes d'ordinateur et à traiter des données. Un tel traitement se fait en parallèle c'est à dire de façon autonome des autres unités. Selon les cas, une architecture multi-coeur comporte également un ou plusieurs des éléments suivants : un processeur, une mémoire, une connexion pour des périphériques d'entrée et de sortie ou un réseau de communication, par exemple, un NoC (de l'anglais *Network on Chip*). Les unités centrales CPU (de l'anglais *Central Processing Unit*) multi-coeurs ou les cartes graphiques GPU (de l'anglais *Graphics Processing Unit)* sont des exemples d'architectures multi-coeurs.

Pour concevoir les architectures multi-coeurs susceptibles de convenir à une application donnée, une approche classique consiste à établir un profil de l'application considérée, puis à implémenter cette application sur l'ensemble des architectures candidates et enfin à optimiser conjointement les architectures et l'application.

Cependant, une telle approche, implique de nombreuses interventions de l'utilisateur, ce qui est chronophage et génère des erreurs.

De nombreux outils visant à explorer de manière automatique les architectures multi-coeurs susceptibles de convenir à une application donnée ont été développés.

Ainsi, il est connu d'utiliser des outils HLS (de l'anglais *High-Level Synthesis*) propres à interpréter une description algorithmique d'un comportement souhaité et à créer l'architecture mettant en oeuvre ce comportement.

Toutefois, pour les performances en termes de temps d'exécution de l'application par l'architecture, de surface occupée par l'architecture et d'énergie consommée par l'architecture, une architecture obtenue automatiquement par de tels outils HLS n'atteint pas les performances qui seraient obtenues manuellement.

Il existe donc un besoin pour un procédé de détermination par optimisation d'une architecture multi-coeurs pour une application donnée qui soit de mise en oeuvre rapide tout en fournissant une architecture multi-coeur ayant des performances en termes de temps d'exécution, de surface et d'énergie consommée plus proches des performances d'une technique d'optimisation manuelle.

A cet effet, l'invention a pour objet un procédé de détermination par optimisation d'une architecture multi-coeurs et d'une façon d'implémenter une application sur l'architecture pour une application donnée, le procédé comprenant :

- la fourniture d'une application parallélisée, une application parallélisée étant un ensemble de tâches,
- la fourniture d'architectures candidates comprenant chacune différents blocs matériels, un bloc matériel présentant une nature spécifique et étant apte à exécuter une ou plusieurs des tâches,
- la définition d'un premier espace d'exploration ayant pour éléments les différentes façons d'implémenter l'application sur chacune des architectures candidates;
- la sélection dans le premier espace d'exploration des éléments vérifiant un premier critère selon lequel chaque tâche de l'application est apte à être mise en oeuvre sur seulement un ou plusieurs blocs matériels, pour obtenir un deuxième espace d'exploration comprenant les éléments du premier espace d'exploration satisfaisant le premier critère,
- la détermination dans le deuxième espace d'exploration des éléments vérifiant un deuxième critère, le deuxième critère étant différent du premier critère et requérant que le nombre de blocs matériels séparant un premier bloc matériel mettant en oeuvre une première tâche et un deuxième bloc matériel mettant en oeuvre une deuxième tâche distincte de la première tâche, soit inférieur ou égal à une valeur propre aux deux tâches considérées, pour obtenir un troisième espace d'exploration comprenant les éléments du deuxième espace d'exploration satisfaisant le deuxième critère,
- le calcul du nombre de données échangées entre les blocs matériels pour chacun des éléments du troisième espace d'exploration et la comparaison de chaque nombre calculé à une valeur seuil, pour obtenir un quatrième espace d'exploration comprenant les éléments du troisième espace d'exploration dont le nombre de données échangées est inférieur ou égal à la valeur seuil, et
- l'optimisation des éléments du quatrième espace d'exploration selon un troisième critère, le troisième critère étant différent du premier critère et du deuxième critère.

Suivant des modes de réalisation particuliers, le procédé de détermination comprend une ou plusieurs des caractéristiques suivantes, prise(s) isolément ou suivant toutes les combinaisons techniquement possibles :

- l'étape de sélection comprend la décomposition parcimonieuse des éléments du premier espace d'exploration sur un dictionnaire, le dictionnaire étant une matrice dont les éléments satisfont au premier critère, les éléments résultant de la décomposition parcimonieuse appartenant au deuxième espace d'exploration,
- le procédé comprend, en outre, les étapes suivantes :

  - la détermination dans l'application des tâches réalisables en même temps par deux blocs matériels distincts d'une même architecture candidate pour obtenir un graphique regroupant l'ensemble des tâches effectuables en parallèle,
  - l'évaluation des besoins nécessaires à la mise en oeuvre de chacune des tâches de l'application sur des blocs matériels spécifiques des architectures candidates afin d'obtenir un tableau regroupant les besoins de chacune des tâches de l'application lorsque les tâches considérées sont réalisées sur lesdits blocs matériels,
  - l'optimisation de l'application sur la base du tableau et du graphique pour réduire le volume des tâches ou le volume des données transférées entre les tâches de l'application (App),

- le premier critère est défini par un utilisateur sur la base du tableau et sur la base de contraintes propres aux architectures candidates et à l'application,

  - le procédé comprend, en outre, les étapes suivantes :
  - la mémorisation dans un cinquième espace d'exploration des éléments du premier espace d'exploration ne satisfaisant pas le premier critère,
  - la mémorisation dans un sixième espace d'exploration des éléments du deuxième espace d'exploration ne satisfaisant pas le deuxième critère,
    l'étape de sélection comprenant, en outre, l'ajout des éléments du cinquième espace d'exploration dans le deuxième espace d'exploration et l'étape de détermination comprenant, en outre, l'ajout des éléments du sixième espace d'exploration dans le troisième espace d'exploration, les étapes de mémorisation étant mises en oeuvre lors du procédé uniquement lorsque l'optimisation des éléments du quatrième espace d'exploration ne satisfait pas le troisième critère,

- la valeur seuil de l'étape de calcul est inférieure aux contraintes en termes de temps d'exécution de l'utilisateur,
- le troisième critère est défini par une fonction dont les paramètres comprennent la taille de l'architecture, le nombre de données transférées entre les différents blocs d'une architecture, la bande-passante et la taille des mémoires de l'architecture, la bande passante des communicateurs de l'architecture, la puissance de calcul des différents blocs matériels, le placement des données et les tâches,
- les natures des blocs matériels sont choisies parmi des processeur, mémoire et communicateur, les blocs matériels composant les architectures candidates ayant été préalablement optimisés pour une ou plusieurs fonctionnalités ou des tâches spécifiques,
- l'étape d'optimisation selon le troisième critère utilisateur met en oeuvre au moins un algorithme de recherche évolutionnaire, tel qu'un algorithme génétique ou un algorithme de recherche tabou.

L'invention concerne aussi un produit programme d'ordinateur comportant un support lisible d'informations, sur lequel est mémorisé un programme d'ordinateur comprenant des instructions de programme, le programme d'ordinateur étant chargeable sur une unité de traitement de données et adapté pour entraîner la mise en oeuvre du procédé précité lorsque le programme d'ordinateur est mis en oeuvre sur l'unité de traitement des données.
D'autres caractéristiques et avantages de l'invention apparaîtront à la lecture de la description qui suit de modes de réalisation de l'invention, donnés à titre d'exemple uniquement et en référence aux dessins qui sont :

- figure 1, une représentation schématique d'un exemple de système permettant la mise en oeuvre d'un procédé de détermination selon l'invention,
- figure 2, un ordinogramme d'un exemple de mise en oeuvre d'un procédé de détermination selon l'invention,
- figure 3, un schéma d'un exemple d'un graphique obtenu lors de la mise en oeuvre du procédé de détermination selon l'invention, et
- figure 4, un schéma d'un exemple de fonctionnement d'un algorithme utilisé lors de la mise en oeuvre du procédé de détermination selon l'invention.

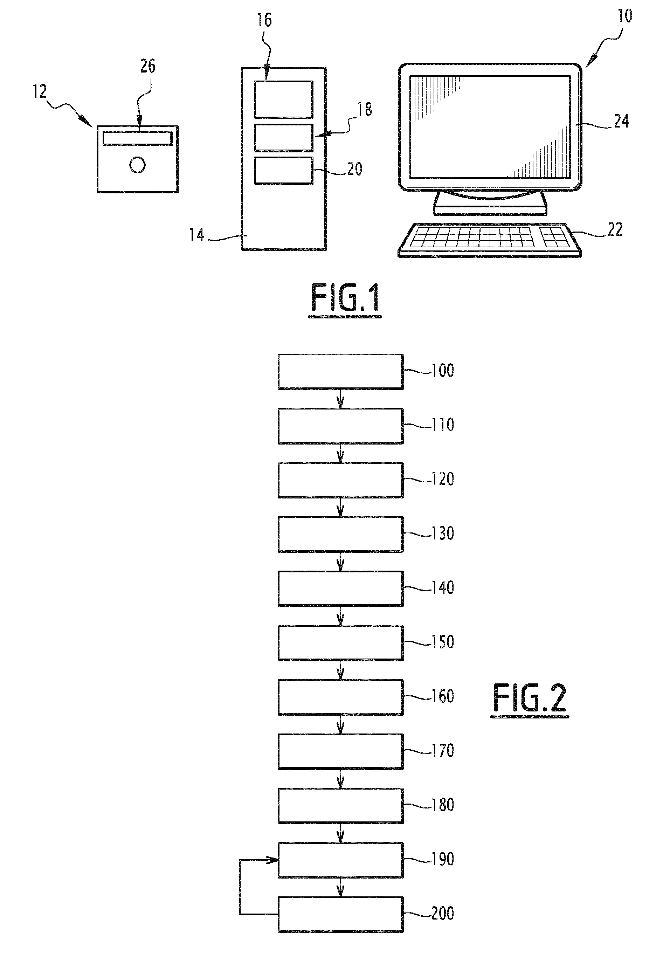

Un système 10 et un produit programme d'ordinateur 12 sont représentés sur la figure 1. L'interaction du produit programme d'ordinateur 12 avec le système 10 permet de mettre en oeuvre un procédé de détermination par optimisation d'une architecture multi-coeurs et d'une façon d'implémenter une application sur l'architecture pour une application donnée.
Le système 10 est un ordinateur.
Plus généralement, le système 10 est un calculateur électronique propre à manipuler et/ou transformer des données représentées comme des quantités électroniques ou physiques dans des registres du système 10 et/ou des mémoires en d'autres données similaires correspondant à des données physiques dans des mémoires, des registres ou autres types de dispositifs d'affichage, de transmission ou de mémorisation.

Le système 10 comporte un processeur 14 comprenant une unité de traitement de données 16, des mémoires 18 et un lecteur 20 de support d'informations. Le système 10 comprend un clavier 22 et une unité d'affichage 24.

Le produit programme d'ordinateur 12 comporte un support lisible d'informations 26.

Le support lisible d'informations 26 est un support lisible par le système 10, usuellement par l'unité de traitement de données 14. Le support lisible d'informations 26 est un médium adapté à mémoriser des instructions électroniques et capables d'être couplé à un bus d'un système informatique.

A titre d'exemple, le support lisible d'informations 26 est une disquette ou disque souple (de la dénomination anglaise *floppy disk*), un disque optique, un CD-ROM, un disque magnéto-optique, une mémoire ROM, une mémoire RAM, une mémoire EPROM, une mémoire EEPROM, une carte magnétique ou une carte optique.

Sur le support lisible d'informations 26 est mémorisé un programme d'ordinateur comprenant des instructions de programme.

Le programme d'ordinateur est chargeable sur l'unité de traitement de données 14 et est adapté pour entraîner la mise en oeuvre d'un procédé de détermination par optimisation d'une architecture multi-coeur et d'une façon d'implémenter une application sur l'architecture pour une application donnée lorsque le programme d'ordinateur est mis en oeuvre sur l'unité de traitement des données 14.

Le fonctionnement du système 10 en interaction avec le produit programme d'ordinateur 12 est maintenant décrit en référence à la figure 2 qui illustre un exemple de mise en oeuvre d'un procédé de détermination selon l'invention.

Le procédé de détermination comprend une étape 100 de fourniture d'une application App parallélisée comportant un ensemble de tâches $T_1,..., T_n$.

Une application App est un ensemble de programmes informatiques conçus de façon à fournir un service à un utilisateur. Une application App est, par exemple, utilisée en vue de remplir une fonction de traitement de texte, de tableur, de bureautique, de gestion de production, de systèmes d'informations, de gestion de projet, de comptabilité ou encore de gestion électronique de documents.

Une tâche $T_1,..., T_n$ est une action ou un calcul défini par une application App et se caractérisant généralement par trois états : « à faire », « en cours » ou « fait ». Une tâche $T_1,..., T_n$ est apte à générer des instructions ou des séquences d'instructions lors de sa mise en oeuvre sur un système physique, tel qu'une architecture. Une tâche $T_1,..., T_n$ est également apte à consommer des données et à produire des données lors de sa mise en oeuvre.

Comme décrit précédemment, une donnée est représentée comme une quantité électronique ou physique. Une telle donnée correspond à une description élémentaire d'une réalité se présentant éventuellement sous forme d'un code informatique. Une donnée consommée signifie que la donnée est utilisée lors de la mise en oeuvre de la tache $T_1,..., T_n$ considérée. Une donnée produite signifie que la donnée est générée par la tâche $T_1,..., T_n$, considérée lors de la mise en oeuvre de la tâche $T_1,..., T_n$.

Le concept d'application parallélisée désigne une application App comportant un ensemble de tâches $T_1,..., T_n$, certaines de ces tâches $T_1,..., T_n$ étant réalisables en même temps par un système physique, par exemple une architecture, sur lequel l'application App est implémentée. Le terme « implémentation » désigne la mise en place sur un système tel qu'un ordinateur, une plateforme de calcul ou une architecture d'un programme informatique tel qu'une application.

L'étape 100 de fourniture d'une application App est généralement mise en oeuvre par fourniture du code source de l'application App.

Le procédé de détermination comprend ensuite une étape 110 de fourniture d'architectures multi-coeurs candidates $Ar_1,..., Ar_n$, comprenant chacune différents blocs matériels $B_1,..., B_n$. Un bloc matériel $B_1,..., B_n$ présente une nature spécifique et est apte à exécuter une ou plusieurs des tâches $T_1,..., T_n$.

De façon générale, une architecture désigne une structure inhérente à un système informatique, l'organisation des éléments du système et les relations entre ces éléments.

Un processeur est un exemple d'architecture.

Un bloc matériel $B_1,..., B_n$ est, par définition, un élément d'une architecture remplissant une fonction ou fonctionnalité prédéterminée, par exemple une fonction de communication ou une fonction de stockage

Une même nature de blocs matériels $B_1,..., B_n$ regroupe, par exemple, les blocs matériels $B_1,..., B_n$ remplissant une fonction prédéterminée ou comportant des composants spécifiques.

Les natures des blocs matériels $B_1,..., B_n$ sont choisies parmi un groupe comportant notamment des processeurs, des mémoires et des communicateurs.

Un processeur ou CPU est un composant d'un ordinateur qui exécute les instructions machine des programmes informatiques.

Une instruction machine est une opération élémentaire qu'un programme informatique demande à un processeur d'effectuer.

Un programme informatique est une séquence d'instructions machines spécifiant étape par étape les opérations à effectuer pour obtenir un résultat.

Les processeurs sont à titre d'exemple des processeurs COTS (de l'anglais *Commercial On The Shelve*) ou des accélérateurs dataflow.

Les processeurs sont généralement aptes à exécuter des tâches d'une application les unes après les autres selon un ordre prédéterminé. Les *General Purpose Processor,* les *Domain Oriented Processor* et les ASIP (de l'anglais *Application Specific Instruction-Set Processor*) sont des exemples de processeurs.

Les accélérateurs dataflow sont quant à eux généralement aptes à exécuter des tâches d'une application dès lors que les données relatives à chacune des tâches sont disponibles. L'ordre d'exécution des tâches n'est alors pas prédéterminé. Un accélérateur data-flow est, par exemple, une unité de calcul réalisant un filtre ou un calcul de transformée de Fourier rapide ou de FFT (de l'anglais *Fast Fourier Transform).*

Une mémoire est un dispositif servant à mémoriser des informations et apte à être intégré dans un système informatique tel qu'un ordinateur.

Les mémoires sont, par exemple, des mémoires partagées aptes à être utilisées par plusieurs programmes simultanément, ces programmes étant implémentés sur un ou plusieurs processeurs. Les mémoires sont, par exemple, des mémoires distribuées dédiées chacune à un processeur.

Un communicateur est un système de communication entre les composants d'un système informatique tel qu'un ordinateur.

Les communicateurs sont, par exemple, des bus informatiques ou des NoC.

Optionnellement, les blocs matériels $B_1$,..., $B_n$ composant les architectures $Ar_1$,..., $Ar_n$ candidates ont été préalablement optimisés pour une ou plusieurs fonctionnalités, telles que, par exemple, une fonction de traitement de texte ou de tableur, ou des tâches $T_1$,..., $T_n$ spécifiques. L'optimisation des blocs matériels $B_1$,..., $B_n$ est réalisée antérieurement à la mise en oeuvre du procédé de détermination, par exemple, par un outil de synthèse de haut niveau ou manuellement par un utilisateur.

L'étape 110 de fourniture d'architectures $Ar_1$,..., $Ar_n$ est généralement mise en oeuvre par fourniture d'une librairie d'architectures à l'unité de traitement de données 16. La librairie d'architecture est, par exemple, représentée grâce au standard IP-XACT.

Le standard IP-XACT est défini dans le document « Evaluating uml2 modeling of ip-xact objects for automatic mpsoc integration onto fpga » de T. Arpinen et al. publié en 2009.

Le procédé de détermination comprend ensuite, optionnellement, une étape 120 de détermination dans l'application App des tâches $T_1$,..., $T_n$ réalisables en même temps par deux blocs matériels $B_1$,..., $B_n$ distincts d'une même architecture $Ar_1$,..., $Ar_n$ candidate. De telles tâches $T_1$,..., $T_n$ réalisables en même temps sont dites « parallèlisables ».

L'étape 120 de détermination permet également d'obtenir un graphique G regroupant l'ensemble des tâches $T_1$,..., $T_n$ effectuables en parallèle.

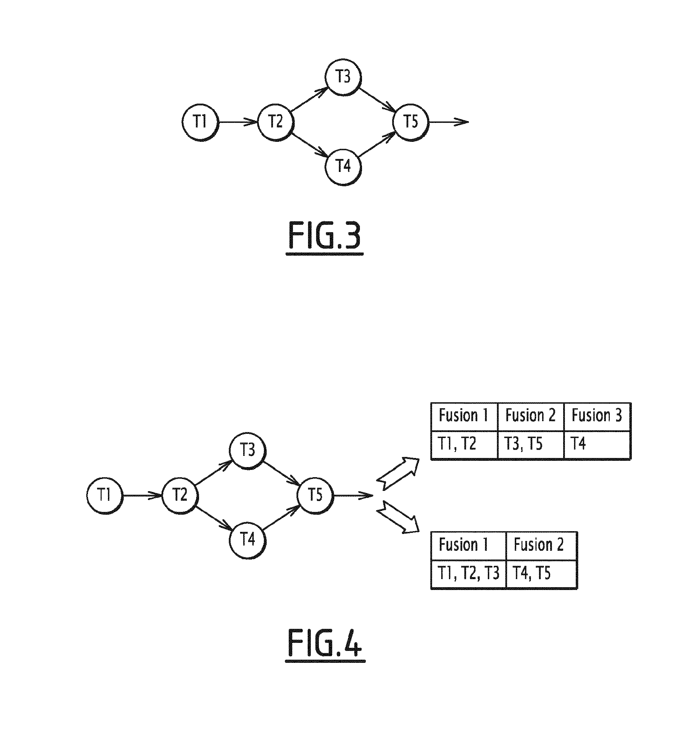

Par exemple, comme visible sur la figure 3, sur un tel graphique G les tâches $T_1$,..., $T_n$ sont reliées les unes aux autres par des flèches modélisant l'ordre d'exécution des tâches $T_1$,..., $T_n$. Sur l'exemple de la figure 3, cinq tâches $T_1$, $T_2$, $T_3$, $T_4$, $T_5$ sont représentées, les tâches $T_3$ et $T_4$ étant parallèlisables.

Un tel graphique G est visualisable par un utilisateur au moyen de l'unité d'affichage 24.

L'étape 120 de détermination des tâches est généralement mise en oeuvre à partir du code source de l'application App et d'un outil de calcul et/ou de compilation ou d'un outil de parallèlisation de code. Par exemple, l'étape 120 est réalisée au moyen du compilateur PIPS (abréviation de *Parallélisation Interprocédurale de Programmes Scientifiques).* Le compilateur PIPS permet d'analyser et de transformer des programmes en langage C et en langage FORTRAN (de l'anglais *Formula Translator).*

Le procédé de détermination comporte, optionnellement, une étape 130 d'évaluation des besoins nécessaires à l'implémentation des tâches $T_1$,..., $T_n$ de l'application App sur les blocs matériels $B_1$,..., $B_n$ spécifiques des architectures $Ar_1$,..., $Ar_n$ candidates.

Les blocs matériels $B_1$,..., $B_n$ spécifiques des architectures $Ar_1$,..., $Ar_n$ candidates sont, par exemple, les blocs matériels $B_1$,..., $B_n$ ayant une nature de processeurs. Plus particulièrement, les blocs matériels $B_1$,..., $B_n$ spécifiques sont des processeurs COTS.

Les besoins évalués sont, notamment, le nombre d'instructions nécessaires à l'exécution, c'est-à-dire à la mise en oeuvre, d'une tâche $T_1$,..., $T_n$ sur un bloc matériel $B_1$,..., $B_n$ spécifique.

A titre d'exemple, les besoins évalués regroupent également le rapport entre la quantité de données produites par chaque tâche $T_1$,..., $T_n$ et la quantité de données consommées par chaque tâche $T_1$,..., $T_n$. Un tel rapport définit ainsi la proportion de données transférées lors de l'exécution d'une tâche $T_1$,..., $T_n$ donnée sur un bloc matériel $B_1$,..., $B_n$ spécifique.

En variante, les besoins évalués sont, également, le temps d'exécution de chaque tâche $T_1$,..., $T_n$ sur chacun des blocs matériels $B_1$,..., $B_n$ de nature processeurs.

L'étape 130 d'évaluation permet d'obtenir un tableau T regroupant les besoins de chacune des tâches $T_1$,...

$T_n$ de l'application App lorsque les tâches $T_1$,.... $T_n$ considérées sont réalisées sur chacun des blocs matériels $B_1$,..., $B_n$ spécifiques.

Un tel tableau T est, par exemple, un tableau regroupant pour chaque tâche $T_1$,..., $T_n$ de l'application App et pour chaque bloc matériel $B_1$,..., $B_n$ spécifique, le nombre d'instructions et le temps d'exécution nécessaires à l'exécution de chacune de ces tâches $T_1$,..., $T_n$ sur chacun de ces blocs matériels $B_1$,..., $B_n$ spécifiques.

Avantageusement, le tableau T regroupe, également, pour chaque tâche $T_1$,..., $T_n$ le rapport entre la quantité de données produites et la quantité de données consommées par la tâche $T_1$,..., $T_n$.

Un tableau T est, par exemple, de la forme suivante :

|  | Nombre d'instructions | | | Données produites / Données consommées (ko) |
|---|---|---|---|---|
|  | $B_1$ | ................. | $B_n$ | |
| $T_1$ | 12500 | ................. | 10500 | 2400/3600 |
| $T_2$ | 5632 | ................. | 5032 | 3600/4000 |
| $T_3$ | 7852 | ................. | 7552 | 4000/2600 |
| $T_4$ | 45236 | ................. | 46236 | 4000/2600 |
| $T_5$ | 78256 | ................. | 79256 | 2600/1300 |

|  | $T_1$ | $T_2$ | $T_3$ | $T_4$ | $T_5$ |
|---|---|---|---|---|---|
| $B_1$ | 2,2 | N/A | 1,4 | 2,1 | 1,7 |
| $B_2$ | 1,45 | 1,6 | N/A | N/A | 1,05 |
| ... | ... | ... | ... | ... | ... |
| ... | ... | ... | ... | ... | ... |
| $B_n$ | N/A | 1,5 | N/A | N/A | 1,2 |

Le premier tableau regroupe les besoins en termes de nombres d'instructions et de rapport entre la quantité de données produites et la quantité de données consommées. Le deuxième tableau regroupe les besoins en termes de temps d'exécution.

Dans un tel tableau, la mention « N/A » signifie que la tâche $T_1$,..., $T_n$ correspondante n'est pas apte à être mise en oeuvre sur le bloc matériel $B_1$,..., $B_n$ correspondant.

Un tel tableau T est visualisable par un utilisateur au moyen de l'unité d'affichage 24.

L'étape 130 d'évaluation des besoins est généralement mise en oeuvre en instrumentant le code source de l'application App, c'est-à-dire en rajoutant des instructions au code source originel de l'application App de sorte à mesurer les besoins des tâches $T_1$,..., $T_n$ de l'application App lors de leur exécution.

Plus particulièrement, cette étape 130 d'évaluation est mise en oeuvre par un outil informatique tel qu'un profileur de code. Un profileur de code est un outil qui consiste à analyser l'exécution d'un logiciel ou d'une application afin de connaître son comportement à l'exécution.

Par exemple, l'étape 130 d'évaluation est réalisée au moyen de l'outil OVP (de l'anglais *Open Virtual Platforms*). L'intérêt de l'outil OVP est qu'il comprend une librairie de processeurs normés, ainsi qu'une interface de programmation de haute qualité pour définir de nouveaux blocs matériels $B_1$,..., $B_n$ de nature processeurs.

Par exemple, l'étape 130 d'évaluation est réalisée au moyen d'un profileur de code tel qu'un profileur CNU ou un valgrind.

Le procédé de détermination comprend ensuite, facultativement, une étape 140 d'optimisation de l'application App sur la base du tableau T et du graphique G.

Cette étape 140 d'optimisation prend en compte les souhaits d'un utilisateur, notamment en ce qui concerne les besoins évalués lors de l'étape 130 d'évaluation.

Par exemple, l'utilisateur peut souhaiter que les besoins évalués lors de l'étape 130 d'évaluation soient réduits. Plus particulièrement, concernant ces besoins évalués lors de l'étape 130 d'évaluation, l'utilisateur peut souhaiter que le temps d'exécution soit réduit, que le nombre d'instructions soit réduit ou encore que le rapport entre la quantité de données produites et la quantité de données consommées soit compris dans une plage de valeurs déterminée.

Les souhaits de l'utilisateur concernent également les ressources utilisées par chaque bloc matériel $B_1$,.... $B_n$.

Ces ressources prennent en compte, par exemple, la charge et la bande passante des blocs matériels $B_1,..., B_n$ de nature mémoire ou la puissance de calcul de chaque bloc matériel $B_1,..., B_n$. L'utilisateur peut souhaiter, par exemple, modifier les ressources utilisées par chaque bloc matériel $B_1,..., B_n$.

L'étape 140 d'optimisation vise donc à modifier l'application App en prenant en compte les souhaits d'un utilisateur.

L'étape 140 d'optimisation permet d'obtenir une application App optimisée pour remplacer l'application App fournie lors de l'étape 100 de fourniture. Cette application App optimisée est ensuite utilisée pour la suite de la mise en oeuvre du procédé de détermination.

L'étape 140 d'optimisation est mise en oeuvre par le processeur 14 et implique généralement l'intervention d'un utilisateur au moyen du clavier 22 notamment.

Le procédé de détermination comprend ensuite une étape 150 de définition d'un premier espace d'exploration $E_1$.

Le premier espace d'exploration $E_1$ a pour éléments les différentes façons d'implémenter l'application App sur chacune des architectures $Ar_1,..., Ar_n$ candidates. Ce premier espace $E_1$ comprend en d'autres termes l'ensemble des possibilités de mises en oeuvre de chacune des tâches $T_1,..., T_n$ de l'application App sur l'ensemble des blocs matériels $B_1,..., B_n$ de chacune des architectures $Ar_1,..., Ar_n$ candidates. Un élément du premier espace d'exploration $E_1$ correspond donc à une implémentation d'une tâche $T_1,..., T_n$ de l'application App sur un bloc matériel $B_1,..., B_n$ d'une architecture $Ar_1,..., Ar_n$ candidate.

Le premier espace d'exploration $E_1$ est, par exemple, une matrice dont les éléments sont les implémentations de chaque tâche $T_1,..., T_n$ sur chacun des blocs matériels $B_1,..., B_n$ des architectures $Ar_1,..., Ar_n$ candidates. Par exemple, la matrice du premier espace d'exploration $E_1$ comprend un nombre de lignes correspondant au nombre de tâches $T_1,..., T_n$ et un nombre de colonnes correspondant au nombre de blocs matériels $B_1,..., B_n$ de l'ensemble des architectures $Ar_1,..., Ar_n$ candidates.

L'étape 150 de définition du premier espace d'exploration $E_1$ est, généralement, mise en oeuvre par le processeur 14 au moyen du support lisible d'informations 26.

Le procédé de détermination comprend ensuite une étape 160 de sélection dans le premier espace d'exploration $E_1$, des éléments satisfaisant un premier critère $C_1$.

Le premier critère $C_1$ spécifie que chaque tâche $T_1,..., T_n$ de l'application App est apte à être implémentée sur seulement un ou plusieurs blocs matériels $B_1,..., B_n$. Le premier critère $C_1$ permet de faire correspondre une tâche $T_1,..., T_n$ à un ensemble de blocs matériels $B_1,..., B_n$. Ainsi, les blocs matériels $B_1,..., B_n$ ne respectant pas le premier critère $C_1$ pour une tâche $T_1,..., T_n$ considérée ne sont plus envisagés pour implémenter la tâche $T_1,..., T_n$ considérée.

Le premier critère $C_1$ est choisi par un utilisateur au moyen du clavier 22 notamment.

Cette étape 160 de sélection permet d'obtenir un deuxième espace d'exploration $E_2$ comprenant les éléments du premier espace d'exploration $E_1$ satisfaisant le premier critère $C_1$.

Le deuxième espace d'exploration $E_2$ est, par exemple, une matrice dont les éléments sont les implémentations de chaque tâche $T_1,..., T_n$ sur chacun des blocs matériels $B_1,..., B_n$ des architectures $Ar_1,..., Ar_n$ candidates, ces implémentations respectant le premier critère $C_1$.

Cette étape 160 de sélection comprend la décomposition parcimonieuse des éléments du premier espace d'exploration $E_1$ sur un dictionnaire D, le dictionnaire D étant une matrice dont les éléments satisfont au premier critère $C_1$, les éléments résultant de la décomposition parcimonieuse appartenant au deuxième espace d'exploration $E_2$.

Usuellement, un signal est représenté sous la forme d'une transformation linéaire de ses coefficients et est dit parcimonieux lorsque la plupart de ses coefficients sont approximativement nuls.

Une décomposition parcimonieuse d'un signal est classiquement une décomposition d'un signal sur un dictionnaire D, ce dictionnaire D comprenant un nombre d'éléments très supérieur à la dimension du signal et une telle décomposition introduisant dans la nouvelle représentation du signal un grand nombre de valeurs nulles.

Dans ce qui suit, les termes en gras désignent des vecteurs.

Classiquement, le vecteur solution y issu de la décomposition parcimonieuse d'un signal vecteur **x** sur le dictionnaire D est donné en notations vectorielles par l'équation $Eq_1$ suivante : $y = D. x$

En l'occurrence, le vecteur solution **y** définit pour chaque tâche $T_1,..., T_n$ de l'application App un bloc matériel $B_1,..., B_n$ spécifique des architectures $Ar_1,..., Ar_n$ candidates apte à mettre en oeuvre la tâche $T_1,..., T_n$ considérée.

Lors d'une décomposition parcimonieuse, le choix du dictionnaire D influe notamment sur le temps de calcul nécessaire à la détermination du vecteur solution y.

Le dictionnaire D est déterminé par un utilisateur qui choisit pour chaque tâche $T_1,..., T_n$ un ensemble de blocs matériels $B_1,..., B_n$.

En particulier, pour déterminer le dictionnaire D, l'utilisateur choisit pour chaque tâche $T_1,..., T_n$ les blocs matériels $B_1,..., B_n$ aptes à respecter des contraintes en termes de temps d'exécution de l'application App sur une architecture.

Par exemple, si un bloc matériel $B_1,..., B_n$ met dix secondes pour exécuter une première tâche $T_1$ et que la

contrainte en termes de temps d'exécution de l'application App est de 5 secondes, ledit bloc matériel $B_1$,..., $B_n$ n'est pas considéré dans le dictionnaire D comme une solution potentielle à l'exécution de la tâche $T_1$.

Par exemple, l'utilisateur définit un dictionnaire D sur la base du tableau suivant :

|       | $B_1$ | $B_2$ | $B_3$ | ... | $B_{10}$ |
|-------|-------|-------|-------|-----|----------|
| $T_1$ | 1     | 0     | 1     | ... | 1        |
| $T_2$ | 1     | 1     | 1     | ... | 1        |
| $T_3$ | 1     | 0     | 0     | ... | 0        |
| $T_4$ | 0     | 1     | 0     | ... | 1        |
| $T_5$ | 0     | 1     | 0     | ... | 1        |

Sur un tel tableau, le nombre 1 signifie que la tâche correspondante est apte à être mise en oeuvre sur le bloc matériel correspondant. Le nombre 0 signifie que la tâche correspondante n'est pas apte à être mise en oeuvre sur le bloc matériel correspondant.

Ainsi, la tâche $T_1$ est apte à être mise en oeuvre sur les blocs matériels $B_1$, $B_3$ et $B_{10}$, la tâche $T_2$ sur les blocs matériels $B_1$, $B_2$, $B_3$ et $B_{10}$ et la tâche $T_3$ sur le bloc matériel $B_1$. Les tâches $T_4$ et $T_5$ sont quant à elles aptes à être mises en oeuvre sur les blocs matériels $B_2$ et $B_{10}$.

Ainsi, lors de l'étape 160 de sélection, un utilisateur est sollicité pour définir le premier critère $C_1$ éventuellement sur la base du tableau T et sur la base de contraintes propres aux architectures $Ar_1$,..., $Ar_n$ candidates et à l'application App.

De telles contraintes sont par exemple, des contraintes en termes de temps d'exécution, de surface et d'énergie consommée.

Le premier critère $C_1$ permet à un utilisateur de déterminer les blocs matériels $B_1$,..., $B_n$ susceptibles de mettre en oeuvre chaque tâche $T_1$,..., $T_n$ de l'application App.

L'étape 160 de sélection est généralement mise en oeuvre par le processeur 14 au moyen du support lisible d'informations 26.

Au cours de l'étape 160 de sélection, l'intervention d'un utilisateur est généralement requise au moyen du clavier 22 notamment.

Le procédé de détermination comprend ensuite une étape 170 de détermination dans le deuxième espace d'exploration $E_2$ des éléments satisfaisant un deuxième critère $C_2$, le deuxième critère $C_2$ étant différent du premier critère $C_1$ de l'étape 160 de sélection.

Le deuxième critère $C_2$ spécifie le nombre maximal de blocs matériels $B_1$,...,$B_n$ séparant, c'est-à-dire servant d'intermédiaires pour acheminer des données ou instructions entre un premier bloc matériel $B_1$ sur lequel est implémentée une première tâche $T_1$ et un deuxième bloc matériel $B_2$ sur lequel est implémentée une deuxième tâche $T_2$ distincte de la première tâche $T_1$.

Le nombre maximal de blocs matériels $B_1$,..., $B_n$ est spécifique aux deux tâches $T_1$, $T_2$ considérées. En d'autre termes, chaque groupe de tâches $T_1$, $T_2$ distinctes comporte un nombre maximal de blocs matériels $B_1$,..., $B_n$ servant d'intermédiaires pour acheminer des données ou instructions entre un premier bloc matériel $B_1$ sur lequel est implémentée la première tâche $T_1$ et un deuxième bloc matériel $B_2$ sur lequel est implémentée la deuxième tâche $T_2$.

Le nombre de blocs matériels $B_1$,..., $B_n$ servant d'intermédiaires à l'acheminement des données ou instructions de deux tâches $T_1$, $T_2$ distinctes doit être inférieur ou égal au nombre maximal de blocs matériels $B_1$,..., $B_n$ spécifiques aux deux tâches $T_1$, $T_2$ considérées pour respecter le deuxième critère $C_2$.

Les nombres maximaux de blocs matériels $B_1$,..., $B_n$ servant d'intermédiaires pour acheminer des données ou instructions entre deux tâches $T_1$,..., $T_n$ distinctes sont généralement compris entre 4 et 20.

Par exemple, le tableau suivant récapitule les nombres maximaux de blocs matériels $B_1$,..., $B_n$ servant d'intermédiaires pour acheminer des données ou instructions entre deux tâches $T_1$,..., $T_n$ distinctes :

|       | $T_1$ | $T_2$ | $T_3$ | $T_4$ | $T_5$ |
|-------|-------|-------|-------|-------|-------|
| $T_1$ | N/A   | 2     | N/A   | N/A   | N/A   |
| $T_2$ | 2     | N/A   | 4     | 4     | N/A   |
| $T_3$ | N/A   | 4     | N/A   | N/A   | 1     |
| $T_4$ | N/A   | 4     | N/A   | N/A   | 2     |
| $T_5$ | N/A   | N/A   | 1     | 2     | N/A   |

Dans ce tableau, la mention « N/A » signifie que les deux tâches considérées ne communiquent pas entre elles.

Cette étape 170 de détermination permet d'obtenir un troisième espace d'exploration $E_3$ comprenant les éléments du deuxième espace d'exploration $E_2$ satisfaisant le deuxième critère $C_2$.

Le troisième espace d'exploration $E_3$ est, par exemple, une matrice dont les éléments sont les implémentations de chaque tâche $T_1,..., T_n$ sur chacun des blocs matériels $B_1,..., B_n$ des architectures $Ar_1,..., Ar_n$ candidates, ces implémentations respectant le premier critère $C_1$ et le deuxième critère $C_2$.

Le deuxième critère $C_2$ est défini par un utilisateur, à l'aide éventuellement du tableau T et du graphique G, de manière à guider le placement des tâches $T_1,..., T_n$ sur les blocs matériels $B_1,..., B_n$.

Par exemple, le deuxième critère $C_2$ permet de spécifier que deux tâches $T_1$, $T_2$ distinctes communiquant l'une avec l'autre soient préférentiellement implémentées sur des blocs matériels $B_1$, $B_2$ tels que les données ou instructions acheminées entre ces deux blocs $B_1$, $B_2$ traversent un nombre restreint de blocs matériels $B_1,..., B_n$ servant d'intermédiaires. Ce nombre restreint de blocs matériels $B_1,..., B_n$ est, par exemple, compris entre 1 et 20 pour chaque tâche $T_1,..., T_n$.

L'étape 170 de détermination est généralement mise en oeuvre par le processeur 14 au moyen du support lisible d'informations 26.

Au cours de cette étape 170 de détermination, l'intervention d'un utilisateur est généralement requise au moyen du clavier 22 notamment.

Le procédé de détermination comprend ensuite une étape 180 de calcul pour chacun des éléments du troisième espace d'exploration $E_3$ du nombre de données échangées entre les tâches $T_1,..., T_n$ implémentées sur les blocs matériels $B_1,..., B_n$.

Lors de cette étape 180 de calcul, les nombres calculés sont ensuite comparés à une valeur seuil $V_s$.

La valeur seuil $V_s$ est choisie de sorte que le temps d'exécution résultant de l'échange des données entre deux blocs $B_1,..., B_n$ soit inférieur ou égal aux contraintes en termes de temps d'exécution imposées par l'utilisateur.

L'étape 180 de calcul permet d'obtenir un quatrième espace d'exploration $E_4$ comportant les éléments du troisième espace d'exploration $E_3$ dont le nombre de données échangées est inférieur ou égal à la valeur seuil $V_s$.

Le quatrième espace d'exploration $E_4$ est, par exemple, une matrice dont les éléments sont les implémentations de chaque tâche $T_1,..., T_n$ sur chacun des blocs matériels $B_1,..., B_n$ des architectures $Ar_1,..., Ar_n$ candidates, ces implémentations respectant le premier critère $C_1$, le deuxième critère $C_2$ et le nombre de données échangées entre les tâches $T_1,..., T_n$ implémentées sur les blocs matériels $B_1,..., B_n$ étant inférieur ou égal à la valeur seuil $V_s$.

L'étape 180 de calcul est généralement mise en oeuvre par le processeur 14 au moyen du support lisible d'informations 26.

Le procédé de détermination comprend ensuite une étape 190 d'optimisation des éléments du quatrième espace d'exploration $E_4$ selon un troisième critère $C_3$, le troisième critère $C_3$ étant différent du premier critère $C_1$ et du deuxième critère $C_2$.

Cette étape 190 d'optimisation permet d'obtenir une architecture $Ar_o$ multi-coeurs optimisée pour l'application App, accessible sous la forme d'un code source tel qu'un code VHDL (de l'anglais *Hardware Description Language*) apte à fonctionner sur n'importe quelle famille de composants FPGA.

Un code VHDL est un code réalisé dans un langage de description de matériel destiné à représenter le comportement ainsi que l'architecture d'un système électronique numérique.

Un FPGA est un circuit logique programmable, c'est-à-dire un circuit intégré logique apte à être reprogrammé après sa fabrication.

Le code source d'architecture, tel qu'un code VHDL, obtenu lors de l'étape 190 est normé.

L'étape 190 d'optimisation permet également d'obtenir une application App éventuellement optimisée, accessible par exemple sous la forme d'un code binaire.

Le troisième critère $C_3$ est défini par une fonction f dite fonction de coût. Une telle fonction de coût f vérifie, par exemple, l'équation $Eq_2$ suivante :

$$f = \alpha.Ar + \beta.Perf$$

où
$\alpha$, $\beta$ sont des paramètres de pondération vérifiant $\alpha + \beta < 1$,
Ar est une fonction caractéristique de l'architecture considérée,
Perf est une fonction caractéristique de la performance.

La fonction Ar évalue la taille de l'architecture considérée au regard de contraintes imposées par l'utilisateur.

Par exemple, la taille de l'architecture s'exprime en nombre de LUT (de l'anglais *Look-Up Table*), en nombre de slices, en nombre de registres et en nombre de portes. Un slice est une zone de mémoire allouée à un programme informatique lors de son exécution Un registre est un emplacement de mémoire interne à un processeur. Une porte est une opération logique.

La fonction Perf est obtenue au moyen d'une simulation, et en particulier une simulation SystemC effectuée par un simulateur.

SystemC est un langage de description de matériel de haut niveau. Un tel langage comprend des classes en langage C++ qui introduisent les concepts nécessaires à la modélisation de matériel. SystemC permet, en effet, une modélisation de systèmes au niveau comportemental.

Afin de générer la simulation SytemC, le placement des tâches $T_1$,..., $T_n$ et des données de l'application App sur l'architecture est fourni en entrée du simulateur, ainsi qu'une modélisation à gros grain du comportement de l'architecture.

Une modélisation à gros grain du comportement d'une architecture est une modélisation limitant le nombre d'échanges et de synchronisations entre les tâches implémentées sur l'architecture modélisée.

La simulation SystemC est, par exemple, réalisée avec l'outil SpearDE.

Un tel système d'évaluation de performance prend en compte au moins l'un des éléments suivants : la taille de l'architecture $Ar_1$,..., $Ar_n$, le nombre de données transférées entre les différents blocs $B_1$,..., $B_n$ d'une architecture $Ar_1$,..., $Ar_n$, la bande-passante et la taille des mémoires de l'architecture $Ar_1$,..., $Ar_n$, la bande passante des communicateurs de l'architecture $Ar_1$,..., $Ar_n$ et la puissance de calcul des différents blocs matériels $B_1$,..., $B_n$, le placement des données et les tâches $T_1$,..., $T_n$.

Les paramètres $\alpha$ et $\beta$ sont fixés par un utilisateur de sorte à guider ou influencer l'exploration. En particulier, le paramètre $\alpha$ oriente l'exploration vers des solutions plus économiques en terme de ressources matérielles utilisées, tandis que le paramètre $\beta$ guide l'exploration vers des solutions de plus haute performance. Ces paramètres $\alpha$ et ß sont fixés en fonction des souhaits de l'utilisateur et des contraintes que l'utilisateur impose.

L'étape 190 d'optimisation consiste à minimiser la fonction de coût f.

Cette étape 190 d'optimisation comprend trois phases.

La première phase consiste à explorer l'ensemble des architectures $Ar_1$,..., $Ar_n$ candidates de sorte à obtenir un premier ensemble d'architectures $Ar_1$,..., $Ar_n$ adaptées à la mise en oeuvre des tâches $T_1$,..., $T_n$ de l'application App. Ce premier ensemble d'architectures $Ar_1$,..., $Ar_n$ comporte un nombre réduit d'architectures par rapport au nombre initial d'architectures $Ar_1$,..., $Ar_n$ candidates.

La deuxième phase consiste à obtenir la meilleure implémentation de l'application App sur chacune des architectures $Ar_1$,..., $Ar_n$ obtenues lors de la première phase.

La troisième phase consiste à obtenir la meilleure partition ou répartition des données de l'application App pour chaque implémentation de l'application App obtenue lors de la deuxième phase.

Ces trois phases sont réalisables par un ou plusieurs algorithmes.

Selon un mode de réalisation préféré, l'étape 190 d'optimisation met en oeuvre au moins un algorithme de recherche évolutionnaire.

Un algorithme de recherche évolutionnaire est notamment un algorithme s'inspirant de la théorie de l'évolution pour faire évoluer un ensemble de solutions à un problème donné dans le but d'obtenir une solution optimale.

Un algorithme de recherche évolutionnaire est, par exemple, un algorithme génétique ou un algorithme de recherche tabou.

Les algorithmes génétiques utilisent usuellement la méthode de sélection naturelle et l'appliquent à une population de solutions potentielles au problème donné, la solution est alors approchée par itérations successives.

Les algorithmes de recherche tabou consistent usuellement à partir d'une position donnée, à en explorer le voisinage et à choisir la position dans ce voisinage minimisant une fonction servant de critère à la détermination de la meilleure solution à un problème d'optimisation.

Dans le mode de réalisation préféré, l'étape 190 d'optimisation met en oeuvre trois algorithmes évolutionnaires distincts correspondant chacun à une phase de l'étape 190 d'optimisation.

L'étape 190 d'optimisation met en oeuvre un premier algorithme génétique pour explorer l'ensemble des architectures $Ar_1$,..., $Ar_n$ candidates, puis un algorithme de recherche tabou pour explorer l'ensemble des implémentations des tâches $T_1$,..., $T_n$ sur les architectures $Ar_1$,..., $Ar_n$ candidates et enfin un deuxième algorithme génétique pour déterminer la meilleure partition des données de l'application App.

Plus particulièrement, le premier algorithme génétique permet d'obtenir un premier ensemble d'architectures $Ar_1$,..., $Ar_n$ adaptées à la mise en oeuvre des tâches $T_1$,..., $T_n$ de l'application App.

Lors de son exécution, le premier algorithme génétique est, en effet, apte à sélectionner les blocs matériels $B_1$,..., $B_n$ des architectures $Ar_1$,..., $Ar_n$ candidates en fonction notamment du nombre et de la nature et de leurs blocs matériels $B_1$,..., $B_n$.

Par exemple, les architectures $Ar_1$,..., $Ar_n$ sélectionnées comprennent un nombre défini de blocs matériels $B_1$,..., $B_n$ de nature processeur, des processeurs spécifiques parmi les blocs matériels $B_1$,..., $B_n$ de nature processeur, des mémoires de taille et de caractéristiques spécifiques parmi les blocs matériels $B_1$,..., $B_n$ de nature mémoire, des communicateurs spécifiques parmi les blocs matériels $B_1,..., B_n$ de nature communicateur.

Le premier algorithme génétique dispose de deux niveaux d'exploration d'un ensemble de solutions : le niveau des noeuds et le niveau de la plateforme.

Les noeuds sont des blocs permettant de construire une plateforme. Deux types de noeuds physiques sont considérés ; les noeuds actifs et les noeuds passifs.

Les noeuds actifs contiennent un ou plusieurs blocs matériels $B_1,..., B_n$ de nature processeur et sont utilisables pour effectuer des opérations de traitement. Par exemple, un noeud actif est un processeur avec une mémoire locale qui lui est propre. Dans un autre exemple, un noeud actif comprend plusieurs processeurs et leurs mémoires locales.

Les noeuds passifs exposent leurs adresses aux autres noeuds. Ces noeuds passifs ne sont pas capables d'effectuer un traitement ou de déclencher des communications. De tels noeuds passifs peuvent être lus ou écrits par les noeuds actifs. Par exemple, les noeuds passifs sont des mémoires partagées sur un NoC ou des composants d'entrée ou de sortie.

Au niveau de la plateforme, le premier algorithme génétique considère l'architecture comme une série de composants d'entrée et de sortie, de mémoires partagées et de noeuds. Cela permet au premier algorithme génétique de comparer les avantages d'un réseau de communication par rapport à un autre, de trouver le nombre optimal de noeuds, de mémoires partagées et de composants d'entrée et de sortie.

Au niveau des noeuds, le premier algorithme génétique détermine s'il est préférable d'ajouter des noeuds actifs ou des noeuds passifs.

Pour explorer l'ensemble de l'espace de solutions que ce soit au niveau des noeuds ou au niveau d'une plateforme, le premier algorithme génétique est apte à modifier plusieurs caractéristiques parmi les caractéristiques suivantes : le nombre de blocs matériels $B_1,..., B_n$, la nature des blocs matériels $B_1,..., B_n$, la mémoire locale de chaque bloc matériel $B_1,..., B_n$, le type de blocs matériels $B_1,..., B_n$ de nature mémoire, la hiérarchie de l'architecture et la topologie des communicateurs.

Le premier algorithme génétique dispose initialement d'une population générée aléatoirement. Une telle génération aléatoire permet d'obtenir une population diversifiée.

Le premier algorithme génétique utilise des opérateurs pour trouver une solution à un problème, notamment un opérateur de sélection, un opérateur de croisement et un opérateur de mutation.

Un opérateur de sélection est utilisé pour choisir dans une population, les individus les plus adaptés pour que l'algorithme converge vers une solution optimale.

Un opérateur de croisement est utilisé pour enrichir la diversité des individus d'une population. Par analogie avec la biologie, un tel opérateur effectue des croisements entre différents chromosomes dans le but de créer de nouvelles séquences de chromosomes fils. De tels croisements ont lieu avec une probabilité fixée par un utilisateur en fonction du problème d'optimisation.

Un opérateur de mutation est, par analogie avec la biologie, un changement aléatoire d'un ou plusieurs gènes d'un chromosome. En général, un tel opérateur de mutation permet de conserver la diversité dans le développement d'individus et empêche la convergence vers un optimum local.

L'algorithme de recherche tabou permet ensuite d'obtenir la meilleure implémentation de l'application App sur chacune des architectures $Ar_1,..., Ar_n$ obtenues avec le premier algorithme génétique.

Le deuxième algorithme génétique permet enfin d'obtenir la meilleure partition ou répartition des données de l'application App pour chaque implémentation de l'application App obtenue avec l'algorithme de recherche tabou.

Une partition de données est une division ou un fractionnement des données en plusieurs groupes de sorte à les répartir sur différentes parties d'une architecture.

Afin d'aider le deuxième algorithme génétique à converger vers une solution optimale pour l'architecture conjointement avec l'application App, il est possible de fournir des caractéristiques de l'application App considérée à l'outil de mise en oeuvre du deuxième algorithme.

Comme visible sur la figure 4, à partir du graphique G regroupant les tâches $T_1,..., T_n$ parallèlisables, le deuxième algorithme génétique génère des chromosomes de manière aléatoire. Les tâches $T_1,..., T_n$ parallèlisables sont fusionnées, c'est-à-dire regroupées sur ces chromosomes dans le but de maintenir la localité des données et éviter, ainsi, les transferts de données inutiles et donc maintenir la performance.

Dans l'exemple de la figure 4, deux chromosomes sont générés à partir du graphique G.. Ainsi, un premier chromosome de cette figure 4 regroupe dans une première fusion une première tâche $T_1$ avec une deuxième tâche $T_2$ et dans une deuxième fusion une troisième tâche $T_3$ avec une cinquième tâche $T_5$. En outre, pour ce premier chromosome, une quatrième tâche $T_4$ dans une troisième fusion n'est regroupée avec aucune autre tâche. Cela signifie que lors de l'exécution des première et deuxième tâches $T_1, T_2$, ces deux tâches $T_1, T_2$ travaillent sur le même sous-ensemble de données. De plus, l'échange de données entre les première et deuxième tâches $T_1$ et $T_2$ ne requiert pas de communication via une mémoire externe. De même, l'échange de données entre les troisième et cinquième tâches $T_3, T_5$ n'implique pas de communication via une mémoire externe. La tâche $T_4$ est, quant à elle, apte à lire des données entrantes dans une mémoire externe et à écrire des données sortantes directement dans la mémoire externe. La troisième fusion avec

la quatrième tâche $T_4$ a pour conséquence de générer des temps de communication importants et de réduire la performance.

Dans le deuxième exemple de chromosome, la première fusion implique une communication avec la mémoire externe pour démarrer la tâche $T_1$ et écrire les résultats issus de la tâche $T_3$. Tandis que la deuxième fusion implique une communication avec la mémoire externe pour démarrer la tâche $T_4$ et écrire les résultats issus de la tâche $T_5$ en mémoire externe.

Le but de cette étape est de réduire les communications avec les mémoires externes et d'optimiser les communications s'effectuant au sein de la plateforme.

L'étape 190 d'optimisation est généralement mise en oeuvre par le processeur 14 au moyen du support lisible d'informations 26.

Ainsi, le procédé de détermination selon l'invention permet la détermination d'une architecture $Ar_o$ multi-coeurs optimisée pour une application App donnée.

Un tel procédé de détermination est de complexité NP, c'est-à-dire à temps polynomial non déterministe. Un tel procédé requiert donc des heuristiques pour explorer l'ensemble des solutions.

Une heuristique est une méthode de calcul qui fournit rapidement une solution réalisable, pas nécessairement optimale ou exacte, à un problème d'optimisation difficile.

Un tel procédé de détermination permet de prendre en compte simultanément les paramètres et contraintes de l'architecture et de l'application, de tels paramètres et contraintes étant dépendants les uns des autres. Une amélioration est donc apportée par rapport aux outils de l'état de la technique qui ne permettent pas de prendre en compte de tels paramètres et contraintes simultanément.

Ainsi, la détermination optimale de l'architecture multi-coeur et de l'application correspondante est facilitée par la réduction de l'espace de solutions, notamment au moyen d'une décomposition parcimonieuse.

En effet, une telle réduction de l'espace de solutions permet d'éliminer d'une part les blocs matériels qui ne correspondent pas aux souhaits d'un utilisateur ou aux contraintes inhérentes à l'architecture et à l'application. D'autre part, une telle réduction de l'espace de solutions permet d'éliminer les implémentations de l'application sur les architectures candidates, qui ne sont pas satisfaisantes ou ne répondent pas aux souhaits d'un utilisateur.

On comprend que lors de cette réduction de l'espace de solutions, l'intervention d'un utilisateur permet de retirer de l'espace de solutions les solutions que l'utilisateur ne souhaite pas explorer. Ainsi, la détermination de la meilleure solution au moyen du procédé de détermination est mise en oeuvre uniquement sur un espace de solution réduit dont les éléments sont susceptibles de constituer des solutions viables.

Dans la mesure où le procédé de détermination explore simultanément les caractéristiques et le potentiel de chaque architecture, de chaque implémentation et de chaque partition des données et que ces caractéristiques sont dépendantes les unes des autres, le procédé de détermination est, par conséquent, mis en oeuvre de manière itérative et il existe une multitude de solutions potentielles à explorer. Ainsi, on comprend que la réduction de l'espace de solutions permet de réduire le temps d'exploration de cet espace de solutions, et donc d'aboutir avec de meilleures probabilités à une solution optimale.

Plus particulièrement, l'exploration de l'ensemble des solutions est basée sur la fourniture de trois entrées, par exemple, le code source de l'application App, une librairie d'architectures candidates, ainsi que des fichiers de contraintes créés par l'utilisateur pour orienter et/ou influencer le procédé de détermination.

Plus particulièrement, le procédé de détermination est mis en oeuvre par cinq outils qui sont, par exemple, un profileur de code, un outil de parallèlisation de code, un outil d'exploration de l'espace de solutions, un outil d'évaluation des performances et un générateur de code binaire.

L'outil d'exploration de l'espace de solutions est, par exemple, implémenté en langage C et en langage Python. Toutefois, d'autres langages d'implémentation sont également possibles tels que par exemple le langage C++ ou encore le langage FORTRAN.

L'outil d'exploration de l'espace de solutions est, par exemple, un outil DSE (de l'anglais *Design Space Exploration*),

Ainsi, lors du procédé de détermination, la recherche de la meilleure solution pour l'architecture et l'application est mise en oeuvre de manière « semi-automatique » dans la mesure où l'intervention d'un utilisateur est requise au cours de certaines étapes du procédé seulement.

Cette approche diffère d'une approche entièrement automatisée telle que mise en oeuvre au moyen d'outils HLS ou d'une approche manuelle.

En effet, une approche entièrement automatisée, bien que de mise en oeuvre rapide, n'est pas toujours optimale quant aux caractéristiques de l'architecture obtenue en termes, notamment, de fréquences, de puissance de consommation ou de quantités de ressources utilisées. Une telle architecture obtenue avec une approche automatisée est donc problématique pour une intégration dans des systèmes embarqués où les fréquences, les puissances de consommation et les quantités de ressources utilisables sont limitées.

Les avantages d'une approche « semi-automatisée » par rapport à une approche entièrement optimisée sont, d'une part, l'utilisation d'architectures ayant déjà été optimisées pour certaines fonctionnalités ou certains types de tâches $T_1,..., T_n$. D'autre part, une telle approche « semi-automatisée » permet d'orienter l'exploration de l'espace de solutions en fonction des contraintes et de souhaits d'un utilisateur. Il est, par exemple, possible d'implémenter plusieurs tâches $T_1,..., T_n$ sur un même bloc matériel $B_1,..., B_n$ dans le but de réduire la quantité de ressources utilisées notamment.

Les avantages d'une approche « semi-automatisée » par rapport à une approche manuelle sont que tous les aspects relatifs à une exploration d'un espace de solutions, notamment, les caractéristiques de l'application App, de l'architecture et de l'implémentation sont pris en compte. En effet, lorsqu'un outil d'exploration tel qu'un DSE évalue une solution, il évalue les caractéristiques de l'application App, de l'architecture et de l'implémentation alors que ces caractéristiques sont dépendantes les unes des autres. La solution finale est donc un compromis des caractéristiques de l'application App, de l'architecture et de l'implémentation.

Un autre avantage d'une approche « semi-automatisée » par rapport à une approche manuelle est que la définition de l'architecture optimale est en partie automatisée, l'utilisateur n'est donc plus sollicité pour les étapes les plus exhaustives. Dans l'approche « semi-automatisée », le rôle principal de l'utilisateur est d'assigner à chaque tâche $T_1,..., T_n$ de l'application App un groupe de blocs matériels $B_1,..., B_n$. L'identification du meilleur compromis possible pour optimiser à la fois l'application et l'architecture est réalisée de manière automatique.

Enfin, un autre avantage de l'invention est qu'elle permet de réduire le temps de conception de l'architecture optimale et de l'application correspondante, et donc de réduire le temps avant une première commercialisation.

Lors de l'étape 190 d'optimisation, la combinaison de trois algorithmes évolutionnaires permet d'explorer chaque architecture en interaction avec chaque implémentation possible et chaque partition des données possible. Cette combinaison de trois algorithmes évolutionnaires assure, ainsi, la détermination du meilleur compromis pour l'architecture et l'application correspondante.

De plus, lors de la mise en oeuvre du procédé de détermination, un code source pour l'architecture correspondant à la meilleure solution, est obtenu de manière automatique. Ce code source comprend plusieurs familles d'accélérateurs, par exemple, des accélérateurs dataflow ou des *General Purpose Processors*. Un tel code source d'architecture présente un intérêt par rapport aux architectures générées à l'aide d'outils HLS. En effet, de tels outils HLS sont construits principalement à partir d'accélérateur dataflow, ce qui peut être limitant dans les domaines embarqués où la quantité de ressources disponibles est limitée.

De plus, depuis que les architectures sont construites au moyen de dispositifs ne prenant pas en compte la complexité des communications, l'architecture $Ar_o$ obtenue suite au procédé de détermination est totalement transparente, c'est-à-dire facile à prendre en main, pour un utilisateur.

Ce procédé de détermination est de mise en oeuvre rapide avec un gain de temps de l'ordre de plusieurs mois par rapport à une optimisation manuelle, et ce notamment grâce aux différents critères $C_1$, $C_2$, $C_3$ et valeurs seuils $V_s$ aptes à réduire l'espace d'exploration $E_1$ de départ.

Les performances de l'architecture $Ar_o$ obtenue avec un tel procédé notamment en termes de temps d'exécution sont proches de celles qui seraient obtenues manuellement. En particulier, avec un tel procédé on obtient moins de 7% en moyenne en termes de surcoût sur le temps d'exécution.

Ainsi, le procédé de détermination par optimisation d'une architecture multi-coeurs pour une application donnée selon l'invention est de mise en oeuvre rapide tout en fournissant une architecture multi-coeur ayant des performances en termes de temps d'exécution, de surface et d'énergie consommée proches des performances d'une technique d'optimisation manuelle.

Optionnellement, lorsque l'optimisation des éléments du quatrième espace d'exploration $E_4$ ne satisfait pas le troisième critère $C_3$, le procédé de détermination comprend une étape 200 de mémorisation.

Cette étape 200 de mémorisation consiste d'une part à mémoriser dans un cinquième espace d'exploration $E_5$ les éléments du premier espace d'exploration $E_1$ ne satisfaisant pas le premier critère $C_1$, c'est-à-dire les implémentations des tâches $T_1,..., T_n$ sur des blocs matériels $B_1,..., B_n$ ne satisfaisant pas le premier critère $C_1$.

Cette étape 200 de mémorisation consiste d'autre part à mémoriser dans un sixième espace d'exploration $E_6$ les éléments du deuxième espace d'exploration $E_2$ ne satisfaisant pas le deuxième critère $C_2$ ni le premier critère $C_1$, c'est-à-dire les implémentations des tâches $T_1,..., T_n$ sur des blocs matériels $B_1,..., B_n$ ne satisfaisant pas le premier critère $C_1$, ni le deuxième critère $C_2$.

Le cinquième espace d'exploration $E_5$ et le sixième espace d'exploration $E_6$ sont, par exemple, des matrices. La matrice du cinquième espace d'exploration $E_5$ a pour élément les implémentations des tâches $T_1,..., T_n$ de l'application App sur des blocs matériels $B_1,..., B_n$ ne satisfaisant pas le premier critère $C_1$. La matrice du sixième espace d'exploration $E_6$ a pour élément les implémentations des tâches $T_1,..., T_n$ de l'application App sur des blocs matériels $B_1,..., B_n$ ne satisfaisant pas le premier critère $C_1$, ni le deuxième critère $C_2$.

L'étape 160 de sélection comprend, en outre, l'ajout des éléments du cinquième espace d'exploration $E_5$ dans le deuxième espace d'exploration $E_2$.

L'étape 170 de détermination comprend, en outre, l'ajout des éléments du sixième espace d'exploration $E_6$ dans le troisième espace d'exploration $E_3$, de sorte que l'étape 190 d'optimisation soit mise en oeuvre sur un espace de solutions plus large.

**Revendications**

1. Procédé de détermination par optimisation d'une architecture multi-coeurs et d'une façon d'implémenter une application (App) sur l'architecture pour une application (App) donnée, le procédé comprenant :

   - la fourniture (100) d'une application (App) parallélisée, une application (App) parallélisée étant un ensemble de tâches $(T_1,..., T_n)$,
   - la fourniture (110) d'architectures $(Ar_1,..., Ar_n)$ candidates comprenant chacune différents blocs matériels $(B_1,..., B_n)$, un bloc matériel $(B_1,..., B_n)$ présentant une nature spécifique et étant apte à exécuter une ou plusieurs des tâches $(T_1,..., T_n)$,
   - la définition (150) d'un premier espace d'exploration $(E_1)$ ayant pour éléments les différentes façons d'implémenter l'application (App) sur chacune des architectures $(Ar_1,..., Ar_n)$ candidates;
   - la sélection (160) dans le premier espace d'exploration $(E_1)$ des éléments vérifiant un premier critère $(C_1)$ selon lequel chaque tâche $(T_1,..., T_n)$ de l'application (App) est apte à être mise en oeuvre sur seulement un ou plusieurs blocs matériels $(B_1,..., B_n)$, pour obtenir un deuxième espace d'exploration $(E_2)$ comprenant les éléments du premier espace d'exploration $(E_1)$ satisfaisant le premier critère $(C_1)$,
   - la détermination (170) dans le deuxième espace d'exploration $(E_2)$ des éléments vérifiant un deuxième critère $(C_2)$, le deuxième critère $(C_2)$ étant différent du premier critère $(C_1)$ et requérant que le nombre de blocs matériels $(B_1,..., B_n)$ séparant un premier bloc matériel $(B_1,..., B_n)$ mettant en oeuvre une première tâche $(T_1,..., T_n)$ et un deuxième bloc matériel $(B_1,..., B_n)$ mettant en oeuvre une deuxième tâche $(T_1,..., T_n)$ distincte de la première tâche $(T_1,..., T_n)$, soit inférieur ou égal à une valeur propre aux deux tâches $(T_1,..., T_n)$ considérées, pour obtenir un troisième espace d'exploration $(E_3)$ comprenant les éléments du deuxième espace d'exploration $(E_2)$ satisfaisant le deuxième critère $(C_2)$,
   - le calcul (180) du nombre de données échangées entre les blocs matériels $(B_1,..., B_n)$ pour chacun des éléments du troisième espace d'exploration $(E_3)$ et la comparaison de chaque nombre calculé à une valeur seuil $(V_s)$, pour obtenir un quatrième espace d'exploration $(E_4)$ comprenant les éléments du troisième espace d'exploration $(E_3)$ dont le nombre de données échangées est inférieur ou égal à la valeur seuil $(V_s)$, et
   - l'optimisation (190) des éléments du quatrième espace d'exploration $(E_4)$ selon un troisième critère $(C_3)$, le troisième critère $(C_3)$ étant différent du premier critère $(C_1)$ et du deuxième critère $(C_2)$.

2. Procédé selon la revendication 1, dans lequel l'étape de sélection (160) comprend la décomposition parcimonieuse des éléments du premier espace d'exploration $(E_1)$ sur un dictionnaire (D), le dictionnaire (D) étant une matrice dont les éléments satisfont au premier critère $(C_1)$, les éléments résultant de la décomposition parcimonieuse appartenant au deuxième espace d'exploration $(E_2)$.

3. Procédé selon la revendication 1 ou 2, dans lequel le procédé comprend, en outre, les étapes suivantes :

   - la détermination (120) dans l'application (App) des tâches $(T_1,..., T_n)$ réalisables en même temps par deux blocs matériels $(B_1,..., B_n)$ distincts d'une même architecture $(Ar_1,..., Ar_n)$ candidate pour obtenir un graphique (G) regroupant l'ensemble des tâches $(T_1,..., T_n)$ effectuables en parallèle,
   - l'évaluation (130) des besoins nécessaires à la mise en oeuvre de chacune des tâches $(T_1,..., T_n)$ de l'application (App) sur des blocs matériels $(B_1,..., B_n)$ spécifiques des architectures $(Ar_1,..., Ar_n)$ candidates afin d'obtenir un tableau (T) regroupant les besoins de chacune des tâches $(T_1,..., T_n)$ de l'application (App) lorsque les tâches $(T_1,..., T_n)$ considérées sont réalisées sur lesdits bloc matériels $(B_1,..., B_n)$.
   - l'optimisation (140) de l'application (App) sur la base du tableau (T) et du graphique (G) pour réduire le volume des tâches $(T_1,..., T_n)$ ou le volume des données transférées entre les tâches $(T_1,..., T_n)$ de l'application (App).

4. Procédé selon la revendication 3, dans lequel le premier critère $(C_1)$ est défini par un utilisateur sur la base du tableau (T) et sur la base de contraintes propres aux architectures $(Ar_1,..., Ar_n)$ candidates et à l'application (App).

5. Procédé selon l'une quelconque des revendications 1 à 4, dans lequel le procédé comprend, en outre, les étapes suivantes :

   - la mémorisation (200) dans un cinquième espace d'exploration $(E_5)$ des éléments du premier espace d'exploration $(E_1)$ ne satisfaisant pas le premier critère $(C_1)$,

- la mémorisation (200) dans un sixième espace d'exploration ($E_6$) des éléments du deuxième espace d'exploration ($E_2$) ne satisfaisant pas le deuxième critère ($C_2$),
l'étape de sélection (160) comprenant, en outre, l'ajout des éléments du cinquième espace d'exploration ($E_5$) dans le deuxième espace d'exploration ($E_2$) et l'étape de détermination (170) comprenant, en outre, l'ajout des éléments du sixième espace d'exploration ($E_6$) dans le troisième espace d'exploration ($E_3$), les étapes de mémorisation étant mises en oeuvre lors du procédé uniquement lorsque l'optimisation des éléments du quatrième espace d'exploration ($E_4$) ne satisfait pas le troisième critère ($C_3$).

6. Procédé selon l'une quelconque des revendications 1 à 5, dans lequel la valeur seuil ($V_s$) de l'étape de calcul est inférieure aux contraintes en termes de temps d'exécution de l'utilisateur.

7. Procédé selon l'une quelconque des revendications 1 à 6, dans lequel le troisième critère ($C_3$) est défini par une fonction (f) dont les paramètres comprennent la taille de l'architecture ($Ar_1$,..., $Ar_n$), le nombre de données transférées entre les différents blocs ($B_1$,..., $B_n$) d'une architecture ($Ar_1$,..., $Ar_n$), la bande-passante et la taille des mémoires de l'architecture ($Ar_1$,..., $Ar_n$), la bande passante des communicateurs de l'architecture ($Ar_1$,..., $Ar_n$), la puissance de calcul des différents blocs matériels ($B_1$,..., $B_n$), le placement des données et les tâches ($T_1$,..., $T_n$).

8. Procédé selon l'une quelconque des revendications 1 à 7, dans lequel les natures des blocs matériels ($B_1$,..., $B_n$) sont choisies parmi des processeur, mémoire et communicateur, les blocs matériels ($B_1$,..., $B_n$) composant les architectures ($Ar_1$,..., $Ar_n$) candidates ayant été préalablement optimisés pour une ou plusieurs fonctionnalités ou des tâches ($T_1$,..., $T_n$) spécifiques.

9. Procédé selon l'une quelconque des revendications 1 à 8, dans lequel l'étape d'optimisation (190) selon le troisième critère utilisateur ($C_3$) met en oeuvre au moins un algorithme de recherche évolutionnaire, tel qu'un algorithme génétique ou un algorithme de recherche tabou.

10. Produit programme d'ordinateur comportant un support lisible d'informations, sur lequel est mémorisé un programme d'ordinateur comprenant des instructions de programme, le programme d'ordinateur étant chargeable sur une unité de traitement de données et adapté pour entraîner la mise en oeuvre d'un procédé selon l'une quelconque des revendications 1 à 9 lorsque le programme d'ordinateur est mis en oeuvre sur l'unité de traitement des données.

26

12

16

18

20

14

10

24

22

## FIG.1

100

110

120

130

140

150

160

170

180

190

200

## FIG.2

FIG.3

| Fusion 1 | Fusion 2 | Fusion 3 |
|----------|----------|----------|
| T1, T2   | T3, T5   | T4       |

| Fusion 1     | Fusion 2 |
|--------------|----------|
| T1, T2, T3   | T4, T5   |

FIG.4

Europäisches
Patentamt

European
Patent Office

Office européen
des brevets

# RAPPORT DE RECHERCHE EUROPEENNE

Numéro de la demande

EP 15 18 1636

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | BRILLU ROMAIN ET AL: "Towards a Design Space Exploration Tool for MPSoC Platforms Designs: A Case Study", 2014 22ND EUROMICRO INTERNATIONAL CONFERENCE ON PARALLEL, DISTRIBUTED, AND NETWORK-BASED PROCESSING, IEEE, 12 février 2014 (2014-02-12), pages 466-473, XP032584952, ISSN: 1066-6192, DOI: 10.1109/PDP.2014.116 [extrait le 2014-04-11] * le document en entier * ----- | 1-10 | INV. G06F9/50 G06F17/50 |
| A | MURALI S ET AL: "SUNMAP: a tool for automatic topology selection and generation for NoCs", DESIGN AUTOMATION CONFERENCE, 2004. PROCEEDINGS. 41ST, IEEE, PISCATAWAY, NJ, USA, 7 juillet 2004 (2004-07-07), pages 914-919, XP031995497, ISBN: 978-1-5118-3828-3 * page 915, colonne de droite, ligne 10 - dernière ligne; figure 1 * ----- | 1-10 | |
| A | US 2011/302550 A1 (JACKSON ETHAN K [US] ET AL) 8 décembre 2011 (2011-12-08) * le document en entier * ----- -/-- | 1-10 | |

DOMAINES TECHNIQUES RECHERCHES (IPC)

G06F

Le présent rapport a été établi pour toutes les revendications

| Lieu de la recherche | Date d'achèvement de la recherche | Examinateur |
|---|---|---|
| La Haye | 2 février 2016 | Michel, Thierry |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...............................................................
& : membre de la même famille, document correspondant

EPO FORM 1503 03.82 (P04C02)

Europäisches
Patentamt

European
Patent Office

Office européen
des brevets

**RAPPORT DE RECHERCHE EUROPEENNE**

Numéro de la demande

EP 15 18 1636

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | BENOÎT MIRAMOND ET AL: "OveRSoC: A Framework for the Exploration of RTOS for RSoC Platforms", INTERNATIONAL JOURNAL OF RECONFIGURABLE COMPUTING, vol. 1, no. 3-4, 1 janvier 2009 (2009-01-01), pages 1-22, XP055190614, ISSN: 1687-7195, DOI: 10.1155/2008/349465 * page 4, colonne de gauche, ligne 45 - page 5, colonne de droite, ligne 49; figure 1 * | 1-10 | |

-----

DOMAINES TECHNIQUES RECHERCHES (IPC)

Le présent rapport a été établi pour toutes les revendications

| Lieu de la recherche | Date d'achèvement de la recherche | Examinateur |
|---|---|---|
| La Haye | 2 février 2016 | Michel, Thierry |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.................................................
& : membre de la même famille, document correspondant

EPO FORM 1503 03.82 (P04C02)

**EP 2 996 040 A1**

## ANNEXE AU RAPPORT DE RECHERCHE EUROPEENNE
## RELATIF A LA DEMANDE DE BREVET EUROPEEN NO.

EP 15 18 1636

02-02-2016

| Document brevet cité au rapport de recherche | Date de publication | Membre(s) de la famille de brevet(s) | Date de publication |
|---|---|---|---|
| US 2011302550 A1 | 08-12-2011 | AUCUN | |

EPO FORM P0460

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **T. ARPINEN et al.** *Evaluating uml2 modeling of ip-xact objects for automatic mpsoc integration onto fpga,* 2009